# EUROPEAN PATENT SPECIFICATION

(11) **EP 2 593 591 B1**
(45) Date of publication and mention of the grant of the patent: **08.06.2016**
(21) Application number: 11738426.3
(22) Date of filing: 13.07.2011
(51) Int. Cl.: C25D 19/00, H01L 21/00, C25D 21/08, H01L 21/67, C25D 5/02, C25D 7/12, H01L 21/288, C25D 17/00, C25D 17/06, C25D 17/10

(54) **METHOD FOR RINSING AND/OR DRYING AN ECPR CHAMBER, AND CHUCKS AND CHUCK ASSEMBLIES THEREFORE**
VERFAHREN ZUM SPÜLEN UND/ODER TROCKNEN EINER ECPR-KAMMER, SPANNFUTTER UND SPANNFUTTERANORDNUNGEN DAFÜR
PROCÉDÉ DE RINÇAGE ET/OU DE SÉCHAGE D'UNE CHAMBRE DE RÉPLICATION ÉLECTROCHIMIQUE DE MOTIFS (ECPR), ET MANDRINS ET ENSEMBLES DE MANDRINS CORRESPONDANTS

(30) Priority: 16.07.2010 US 364989 P; 15.07.2010 SE 1050801
(43) Date of publication of application: 22.05.2013
(73) Proprietor: Luxembourg Institute of Science and Technology (LIST), 4362 Esch-sur-Alzette (LU)
(72) Inventor: MÖLLER, Patrik, S-112 32 Stockholm (SE); LINDGREN, Lennart, S-125 33 Älvsjö (SE); SVENSSON, Stefan, S-182 31 Danderyd (SE); CHAUVET, Jean-Michel, S-125 43 Älvsjö (SE); SANTOS, Antonio, S-164 45 Kista (SE); FREDENBERG, Mikael, S-112 45 Stockholm (SE)
(74) Representative: Lecomte & Partners
(86) International application number: PCT/EP2011/061995
(87) International publication number: WO 2012/007525

(56) References cited:
- EP-A2- 1 431 424
- WO-A1-02/103085
- US-A1- 2008 053 488

## Description

### Field of the Invention

This invention pertains in general to the field of electrochemical pattern replication. More particularly the invention relates to a method for rinsing and/or drying an ECPR chamber, and a master electrode and substrate positioned therein, and chucks and chuck assemblies therefore.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can also be used for different types of structures in conductive polymers, structures in semiconductors, structures in metals, and others. Even 3D-structures in silicon, such as by formation of porous silicon, are possible.

Chemical vapour deposition and physical vapour deposition are processes that may also be used for metallization, but electroplating/electroetching is often preferred since it is generally less expensive than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface on the master electrode, an insulating material, defining the pattern to be plated/etched, and the conductive surface of the substrate. During plating, a predeposited anode material has been arranged, normally through electrochemical plating, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

However, after plating/etching the master electrode and the substrate are still wet and particular matter resulting from the plating/etching process may be present in the ECPR chamber, on the master electrode, and on the substrate, making the ECPR chamber unsuitable for subsequent plating/etching; making the master electrode unsuitable for reuse or stacking in a master stack; and making the substrate unsuitable for further processing, handling or storage. Also, as soon as printing/etching is performed, the risk of oxidation of the substrate increases rapidly. Furthermore, it is demolishing to get dried electrolyte on the substrate and the master electrode, since this will hamper product quality and further use.

US2008/0053488 describes a substrate treatment apparatus comprising a chuck for holding a substrate and a separate disc-shaped plate positioned on the opposite side of the substrate to the chuck and provided with a plurality of inlet and outlet ports for rinsing and drying the substrate. EP1431424 discloses a chuck incorporating a rinsing outlet to supply a cleaning liquid through a central hole in the substrate and spread it by spinning the substrate.

### Summary of the Invention

Accordingly, the present invention preferably seeks to mitigate, alleviate or eliminate one or more of the above-identified deficiencies in the art and disadvantages singly or in any combination with a chuck for holding a substrate or master electrode in an ECPR process, comprising an interaction surface for a master electrode or a substrate; holding means for holding the substrate or master electrode on said interaction surface; a chuck surface circumferentially of the interaction surface; and at least one drying or rinsing inlet and at least one drying or rinsing outlet on said chuck surface, said at least one drying or rinsing inlet and the at least one drying or rinsing outlet are positioned on opposing sides of the interaction surface in relation to each other; a chuck assembly for holding a substrate or master electrode in an ECPR process, comprising a chuck according to above, and an opposing chuck, said opposing chuck providing a roof over the at least one inlet, and a fluid and/or gas tight seal being shaped to partly enclose the at least one inlet; and a method of cleaning a sealed ECPR chamber after printing and separation of a master electrode and a substrate arranged on opposing chucks, said method comprising a rinsing step comprising: injecting a flow of a rinsing fluid through at least one inlet on one side of the master electrode and the substrate across the master electrode and the substrate; and evacuating the rinsing fluid through at least one outlet on the other side of the master electrode and substrate.

Further advantageous embodiments will be apparent from the appended dependent claims.

### Brief Description of the Drawings

These and other aspects, features and advantages of which the invention is capable of will be apparent and elucidated from the following description of embodiments of the present invention, reference being made to the accompanying drawings, in which
Fig. 1 is a top view of a chuck according to one embodiment of the present invention:
Fig. 2 is a cross sectional view of a part of a chuck according to one embodiment of the present invention;
Fig. 3 is a perspective view of a chuck according to one embodiment of the present invention; and
Fig. 4 is a perspective view of a chuck according to one embodiment of the present invention.

### Description of embodiments

The following description focuses on embodiments of the present invention applicable to a method for filling, rinsing and/or drying an ECPR chamber during an ECPR process. However, it will be appreciated that the invention is not limited to this application but may be applied to many other replication, patterning or bonding processes within the field of micro electronics and/or mechanics where rinsing and/or drying substrates or a process chamber or portions thereof is desired, including for example wafer bonding, various lithographic processes, dry or wet etching processes, etc.

During an ECPR process a master electrode and a substrate are mounted on lower chuck and upper chuck, respectively. An ECPR chamber is created by sealing of the surroundings from the master electrode and substrate, with a fluid and/or gas tight seal. The ECPR chamber and the interface between the master electrode and substrate are filled with an electrolyte. Thereafter, the master electrode and the substrate are compressed, and the electrochemical plating/etching is performed. Then the master electrode and the substrate are separated from each other, and awaiting removal from the ECPR chamber. In this position both the master electrode and the substrate are wet from electrolyte, and particular matter may be present on the master electrode and substrate, respectively. To eliminate the problems identified above, it is now important to as fast as possible rinse the master electrode and the substrate from electrolyte, and dry the master electrode and the substrate.

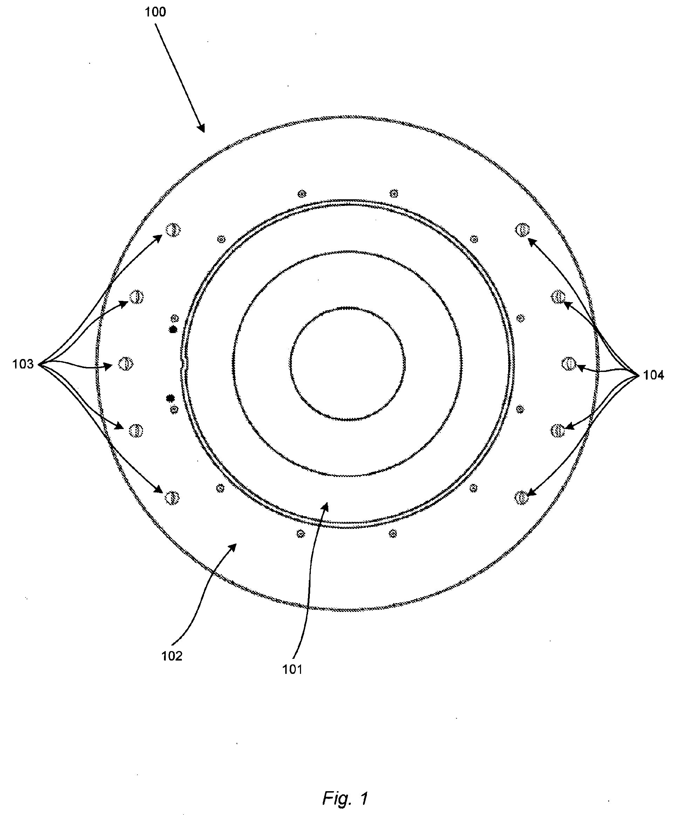

Fig. 1 discloses a top view of a chuck 100 for holding a master electrode or a substrate during ECPR according to one embodiment of the present invention, suitable for rinsing and drying the ECPR chamber, the master electrode and the substrate, after printing and separation of the master electrode and the substrate. The master electrode (not shown) can comprise a conducting disc, at least one insulating layer arranged on the conducting disc, cavities in the insulating layer and/or in the conducting disc, a substantially inert electrode layer arranged in the bottom of said cavities on the conducting disc and may comprise an anode material (such as copper), dissolvable in an electrochemical process, arranged in said cavities on the electrode layer. For the sake of convenience, only embodiments relating to the lower chuck will be described below, although the same arrangements are equally possible for the upper chuck. The chuck 100 comprises a circular interaction surface 101, onto which a master electrode or a substrate is attached. The substrate or the master electrode may be held to the interaction surface by suitable holding means, such as applied vacuum in a sealed off area between the chuck 100 and the substrate or master electrode (not shown), or other mechanical holding means, such as circumferentially arranged clamps etc. On a chuck surface 102, surrounding the interaction surface 101, rinsing and drying inlets 103 and rinsing and drying outlets 104 are arranged. In ECPR, when a master electrode is to be arranged on the chuck 100, the chuck surface 102 may preferably be used for arrangement of the rinsing and drying inlets 103 and outlets 104, since the chuck holding the substrate may need to hold electrical contact means circumferentially of the interaction surface thereof. In this way, the arrangement of master electrode chuck, substrate chuck, electrical means, rinsing/cleaning inlets/outlets, may be obtained in a space efficient way, facilitating the ECPR process. The inlets and outlets are arranged within the fluid and/or gas tight seal, defining the ECPR chamber. The inlets 103 are arranged on the opposing side of the interaction surface 101 in relation to the outlets.

The number of inlets 103 and outlets 104 may vary from 1 to 10, such as from 2 to 10, such as from 3 to 6. When multiple inlets 103 and outlets 104 are used, these may be positioned between the along an extension in the transversal direction corresponding to the diameter of the interaction surface 101, and thus the diameter of the substrate and the master electrode. In this way a very efficient rinsing and drying may be achieved, since satisfactory fluid speed may be achieved, while obtaining a good turbulence, without static and unmoving fluid. Also, due to the arrangement of the inlets and outlets on opposite sides of the interaction surface, the shortest way for the fluid is across the interaction surface. Thus, in one embodiment all lines between any of the inlets to the outlets will cross the interaction surface.

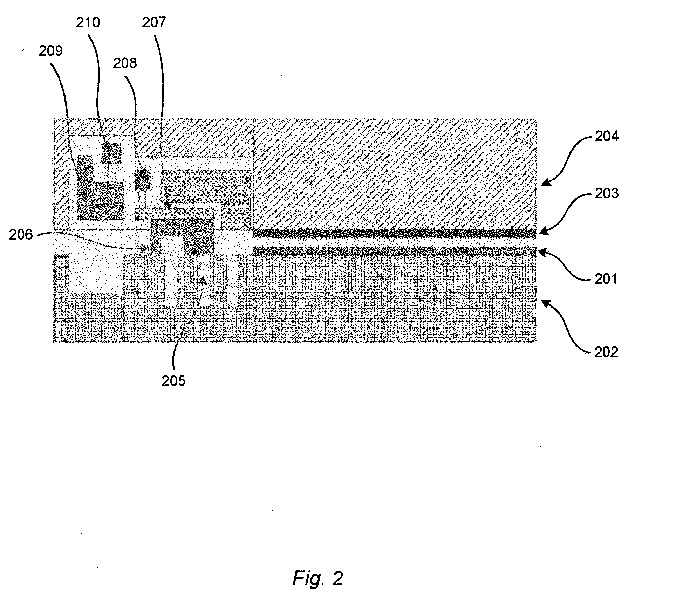

In Fig. 2 a cross section of a part of the ECPR chamber is disclosed. Here a master electrode 201 is positioned on a lower chuck 202, and a substrate 203 is positioned on an upper chuck 204. An inlet 205 is positioned circumferentially of the master electrode 201 Laterally of the inlet 205 the fluid and/or gas tight seal 206 is arranged. An inlet roof 207 may be used, then positioned over the inlet 205. The roof 207 directs the flow of rinsing and drying fluid towards the interaction surface. Also, the seal 206 is shaped to partly enclose the inlet 205. Together, the roof 207 and the seal 206 further helps in directing the fluid over the interaction surface. In one embodiment, the seal 206 is arranged onto a member of the top chuck 204, said member being adjustable in vertical direction, for instance with a pneumatic actuator. During printing the master electrode and master is being in contact with each other, whereby the member and seal 206 is in a first position with respect to the top chuck and creating a seal with an area on the bottom chuck. When separating the master electrode and substrate, by moving the top chuck and bottom chuck away from each other in vertical direction, the member and seal 206 are moved to a second position with respect to the top chuck so that the seal against the bottom chuck is kept.

In one embodiment, the top chuck surface acts as a roof and together with the seal 206 direct the flow towards the interaction surface.

For extra protection against leaks during filling or rinsing of the ECPR chamber, said chamber may comprise a splash ring 208 extendable in vertical direction, positioned outside the seal 206.

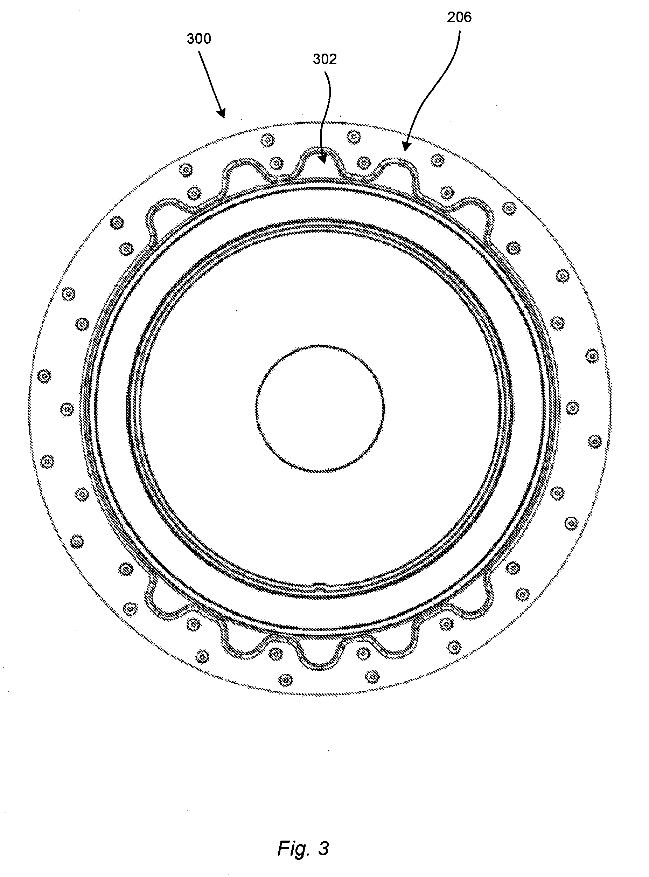

In Fig. 3 a perspective view of an embodiment of an upper chuck 300 is disclosed. Here embodiments of the seal 206 and the roof 207, 302 are further illustrated.

The rinsing step is initiated immediately after or during the separation of the master electrode and the substrate is performed. This can be detected by the software running the ECPR process. The rinsing step is performed while the ECPR chamber is sealed off from the surroundings, such as by the seal 206 disclosed in Figs. 2 and 3. During the rinsing step a rinsing fluid, such as deionized water, is injected through the inlets 103, 205. The rinsing fluid will sweep over the master electrode and the substrate. This rinsing fluid injection prevents oxidation of the electrolyte-covered surfaces, such as the substrate and the master electrode, and prevents drying of electrolyte inside the ECPR chamber. A linear rinsing flow, from one side of the ECPR chamber, and thus from one side of the master electrode and substrate, to the other side of the same, is achieved through pushing rinsing fluid through at least one inlet 103, 205, while simultaneously having open outlets 104 at the other side of the same. An under pressure may be applied at the outlets 104, such that the rinsing fluid is sucked over the interaction surface. In this manner, a double action of the injection force and the outlet suction improves the rinsing effect. To further improve the efficiency of the rinsing and dying operations the transition between the sidewall of the seal 206 and the top surface of the roof 207, 302 can have a curved shape, in order to reduce flow resistance when directing the fluid or gas flow from vertical to horizontal direction of an inlet, and the opposite direction for an outlet. As disclosed above, the arrangement of inlets and outlets on opposing sides of the interaction surface creates a very efficient, high-speed and high-turbulence water flow in the ECPR chamber across the interaction surface.

In one embodiment different inlets 103, 205 are opened in different time periods, and different outlets are opened correspondingly opened at different time periods. In this way a cross-flow of rinsing fluid in different directions can be created over the master electrode and substrate. For instance, in one example five inlets 103 and five outlets 104 may be open at the same time to create a maximum, linear flow of rinsing fluid from one side to the other side of ECPR chamber. Then one or more of the inlets 103 may be turned off, such that complete rinsing in all different directions of the ECPR chamber over the master electrode and the substrate is achieved in a minimum amount of time. This opening and closing of different combinations of inlets 103 and outlets 104 makes the rinsing procedure very efficient.

In another embodiment the top and/or the bottom chuck may be moved up and down with some frequency during the provision of rinsing fluid in accordance with the embodiments disclosed above. This operation changes the effective distance between the master electrode and the substrate, simultaneously with the flow of rinsing fluid through the inlet/inlets 103 and outlet/outlets 104. In this embodiment the seal 206 is extendable upwards and downwards, while keeping its sealing.

When the rinsing step is finished a drying step may be initiated. The drying step may for example be turned on by sensing the conductivity in the outgoing rinsing fluid by a conductivity sensor, and comparing this real time value with a pre-set threshold value. When the threshold value is reached, the drying step is initiated. It is also possible to detect pH or concentration in the same way.

Then, valves in the inlets switch from rinsing fluid to drying fluid, such as nitrogen, helium, argon, or other suitable inert gas. For economical reasons, compressed air may be used in some embodiments. The operation of the provision and discarding of drying gas is performed in line with the operation of the rinsing step and the rinsing fluid. Thus, in a similar manner, a linear drying function with a strong, turbulent airflow is created from one side of the ECPR chamber to the other side, across the substrate and the master electrode, by the use of at least one open inlet 103 and at least one open outlet 104 at the same time. As with the rinsing, higher drying efficiency is achieved by the opening of several inlets 103 and outlets 104 at the same time, and perhaps alternating the opening and closing of different inlets 103 and outlets 104, respectively. For instance, a sequential opening of inlets may be performed.

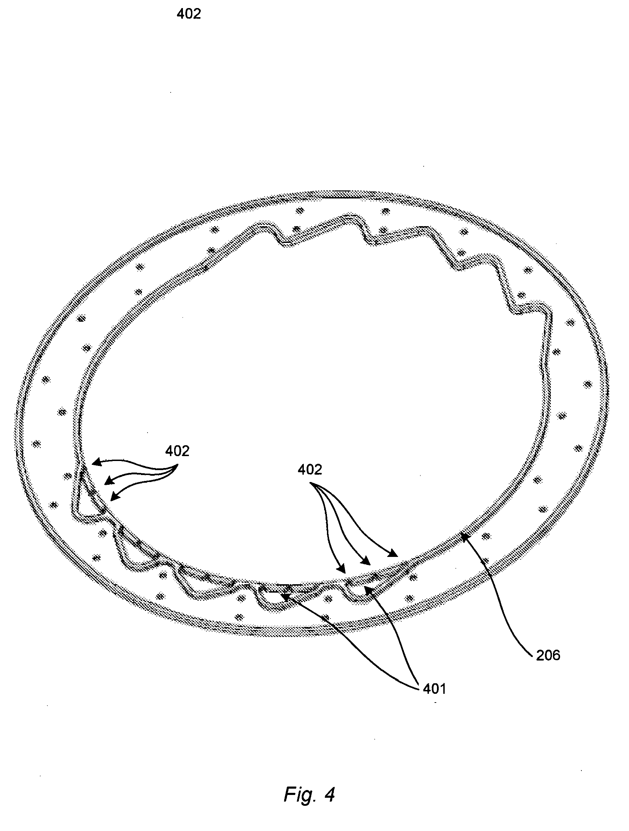

Fig. 4 discloses an embodiment wherein the seal 206 where a volume between the bottom chuck and the roof 401 has been partly enclosed to form a compartment around the inlets 103. The compartments have multiple openings 402 directed towards the interaction surface, thus creating a nozzle with multiple separate openings from each inlet 103, enabling improved distribution and coverage of rinsing fluids or drying gases at the same time as increasing the flow velocity for a given flow rate.

Of course, also the movement of the upper and/or the lower chuck, according to above, does also apply when performing the drying step.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

In the claims, the term "comprises/comprising" does not exclude the presence of other elements or steps. Furthermore, although individually listed, a plurality of means, elements or method steps may be implemented by e.g. a single unit or processor. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A chuck for holding a substrate or master electrode in an electrochemical pattern replication process (ECPR), comprising an interaction surface (101) for a master electrode or a substrate;
holding means for holding the substrate or master electrode on said interaction surface (101);
a chuck surface (102) circumferentially of the interaction surface (101); and at least one drying or rinsing inlet (103) and at least one drying or rinsing outlet (104) on said chuck surface, said at least one drying or rinsing inlet (103) and the at least one drying or rinsing outlet (104) are positioned on opposing sides of the interaction surface (101) in relation to each other.

2. The chuck according to claim 1, wherein a line between any of the at least one inlet (103) to the at least one outlet (104) crosses the interaction surface (101).

3. The chuck according to claim 2, wherein all lines between any of the at least one inlet (103) to the at least one outlet (104) crosses the interaction surface (101).

4. The chuck according to any of the preceding claims, wherein the number of inlets and/or outlets is 2 to 10, such as 3 to 6.

5. The chuck according to any of the preceding claims, wherein the at least one inlet (103) and the at least one outlet (104) are positioned within a fluid and/or gas tight seal (206).

6. A chuck assembly for holding a substrate or master electrode in an ECPR process, comprising a chuck according to any of claims 1 to 5, and an opposing chuck (300), said opposing chuck providing a roof (207) over the at least one inlet (103, 205), and a fluid and/or gas tight seal (206) being shaped to partly enclose the at least one inlet (103, 205).

7. A method of cleaning a sealed printing chamber after printing and separation of a first substrate and a second substrate arranged on opposing chucks (202, 204), said method comprising a rinsing step comprising:
injecting a flow of a rinsing fluid through at least one inlet (103) provided on one chuck surface (202) circumferentially of an interaction surface on one side of the first substrate and the second substrate across the first substrate and the second substrate; and evacuating the rinsing fluid through at least one outlet (104) provided on the chuck surface circumferentially of an interaction surface on the other side of the first substrate and the second substrate.

8. The method according to claim 7, wherein the first substrate is a master electrode for ECPR printing and said printing chamber is an ECPR printing chamber.

9. The method according to claim 8, comprising performing a drying step after the rinsing step, said drying step comprising:
injecting a flow of a drying fluid through the at least one inlet (103) and evacuating the rinsing fluid through the at least one outlet (104).

10. The method according to any of claims 8 or 9, wherein the amount of inlets (103, 205) and outlets (104) is 2 to 10, such as 3 to 6.

11. The method according to claim 10, wherein different inlets (103, 205) are opened in different time periods, and different outlets are opened correspondingly at different time periods.

12. The method according any of claims 9 to 12, comprising moving the top and/or the bottom chuck up and down during the injection of drying fluid.

13. The method according to any of claims 9 to 12, wherein the drying fluid is nitrogen, helium, or argon.

14. The method according to any of claims 9 to 13, wherein the evacuation comprises sucking the drying fluid through at least one outlet in the ECPR chamber.

15. The method according to any of claims 9 to 14, wherein the drying step is turned on and the rinsing step is turned off by sensing the conductivity, pH, and/or concentration in the outgoing rinsing fluid by a sensor;
comparing the obtained value with a pre-set threshold value; and shifting from rinsing to drying when the threshold value is reached.

## Patentansprüche

1. Einspannvorrichtung zum Festhalten eines Substrats oder einer Masterelektrode in einem elektrochemischen Strukturreplikationsverfahren (ECPR), umfassend
eine Interaktionsfläche (101) für eine Masterelektrode oder ein Substrat; Haltemittel zum Festhalten des Substrats oder der Masterelektrode auf der Interaktionsfläche (101);
eine Einspannvorrichtungsfläche (102) in Umfangsrichtung von der Interaktionsfläche (101); und mindestens einen Trocknungs- oder Spüleinlass (103) und mindestens einen Trocknungs- oder Spülauslass (104) an der Einspannvorrichtungsfläche, wobei der mindestens eine Trocknungs- oder Spüleinlass (103) und der mindestens eine Trocknungs- oder Spülauslass (104) in Bezug zueinander an gegenüberliegenden Seiten der Interaktionsfläche (101) angeordnet sind.

2. Einspannvorrichtung nach Anspruch 1, wobei eine Linie zwischen einem des mindestens einen Einlasses (103) zu dem mindestens einen Auslass (104) die Interaktionsfläche (101) kreuzt.

3. Einspannvorrichtung nach Anspruch 2, wobei alle Linien zwischen gleich welchem des mindestens einen Einlasses (103) zu dem mindestens einen Auslass (104) die Interaktionsfläche (101) kreuzen.

4. Einspannvorrichtung nach einem der vorhergehenden Ansprüche, wobei die Anzahl von Einlässen und/oder Auslässen 2 bis 10, wie etwa 3 bis 6, beträgt.

5. Einspannvorrichtung nach einem der vorhergehenden Ansprüche, wobei der mindestens eine Einlass (103) und der mindestens eine Auslass (104) in einer fluid- und/oder gasdichten Abdichtung (206) angeordnet sind.

6. Einspannvorrichtungsanordnung zum Festhalten eines Substrats oder einer Masterelektrode in einem ECPR-Verfahren, umfassend eine Einspannvorrichtung nach einem der Ansprüche 1 bis 5, und eine gegenüberliegende Einspannvorrichtung (300), wobei die gegenüberliegende Einspannvorrichtung ein Dach (207) über dem mindestens einen Einlass (103, 205) bereitstellt, und eine fluid- und/oder gasdichte Abdichtung (206), die so geformt ist, dass sie den mindestens einen Einlass (103, 205) teilweise umschließt.

7. Verfahren zur Reinigung einer verschlossenen Druckkammer nach Drucken und Trennen eines ersten Substrats und eines zweiten Substrats, die an gegenüberliegenden Einspannvorrichtungen (202, 204) angeordnet sind, wobei das Verfahren einen Spülschritt umfasst, umfassend:
Einspritzen eines Stroms eines Spülfluids durch mindestens einen Einlass (103), der an der einen Einspannvorrichtungsfläche (202) in Umfangsrichtung von einer Interaktionsfläche vorgesehen ist, an einer Seite des ersten Substrats und des zweiten Substrats über das erste Substrat und das zweite Substrat; und Abführen des Spülfluids durch mindestens einen Auslass (104), der an der Einspannvorrichtungsfläche in Umfangsrichtung von einer Interaktionsfläche vorgesehen ist, an der anderen Seite des ersten Substrats und des zweiten Substrats.

8. Verfahren nach Anspruch 7, wobei das erste Substrat eine Masterelektrode zum ECPR-Drucken ist und die Druckkammer eine ECPR-Druckkammer ist.

9. Verfahren nach Anspruch 8, umfassend die Durchführung eines Trocknungsschritts nach dem Spülschritt, wobei der Trocknungsschritt umfasst:
Einspritzens eines Stroms eines Trocknungsfluids durch den mindestens einen Einlass (103) und Abführen des Trocknungsfluids durch den mindestens einen Auslass (104).

10. Verfahren nach einem der Ansprüche 8 oder 9, wobei die Anzahl von Einlässen (103, 205) und Auslässen (104) 2 bis 10, wie etwa 3 bis 6, beträgt.

11. Verfahren nach Anspruch 10, wobei verschiedene Einlässe (103, 205) in verschiedenen Zeitspannen geöffnet werden und dementsprechend verschiedene Auslässe zu verschiedenen Zeitspannen geöffnet werden.

12. Verfahren nach einem der Ansprüche 9 bis 12, das Auf- und Abbewegen der oberen und/oder der unteren Einspannvorrichtung während des Einspritzens von Trocknungsfluid umfassend.

13. Verfahren nach einem der Ansprüche 9 bis 12, wobei das Trocknungsfluid Stickstoff, Helium oder Argon ist.

14. Verfahren nach einem der Ansprüche 9 bis 13, wobei das Abführen das Heraussaugen des Trocknungsfluids durch mindestens einen Auslass in der ECPR-Kammer umfasst.

15. Verfahren nach einem der Ansprüche 9 bis 14, wobei der Trocknungsschritt eingeschaltet und der Spülschritt ausgeschaltet wird durch Abtasten der Leitfähigkeit, des pH-Werts und/oder der Konzentration in dem austretenden Spülfluid durch einen Sensor;
Vergleichen des erhaltenen Werts mit einem voreingestellten Schwellenwert; und von Spülen auf Trocknen Umschalten, wenn der Schwellenwert erreicht ist.

## Revendications

1. Mandrin pour maintenir un substrat ou une électrode maître dans un procédé de réplication électrochimique de motifs (ECPR) comprenant :
une surface d'interaction (101) pour une électrode maître ou pour un substrat ;
un moyen de maintien pour maintenir le substrat ou l'électrode maître sur ladite surface d'interaction (101) ;
une surface de mandrin (102) qui entoure la circonférence de la surface d'interaction (101) ; et
au moins une entrée de séchage ou de rinçage (103) et au moins une sortie de séchage ou de rinçage (104) sur ladite surface de mandrin, ladite au moins une entrée de séchage ou de rinçage (103) et ladite au moins une sortie de séchage ou de rinçage (104) étant disposées sur les côtés opposés de la surface d'interaction (101), l'un par rapport à l'autre.

2. Mandrin selon la revendication 1, dans lequel une ligne tracée entre ladite au moins une entrée de séchage ou de rinçage (103) quelle qu'elle soit et ladite au moins une sortie de séchage ou de rinçage (104) quelle qu'elle soit traverse la surface d'interaction (101).

3. Mandrin selon la revendication 2, dans lequel toutes les lignes tracées entre ladite au moins une entrée de séchage ou de rinçage (103) quelle qu'elle soit et ladite au moins une sortie de séchage ou de rinçage (104) quelle qu'elle soit traversent la surface d'interaction (101).

4. Mandrin selon l'une quelconque des revendications précédentes, dans lequel le nombre d'entrées et/ou de sorties s'élève de 2 à 10, par exemple de 3 à 6.

5. Mandrin selon l'une quelconque des revendications précédentes, dans lequel ladite au moins une entrée de séchage ou de rinçage (103) et ladite au moins une sortie de séchage ou de rinçage (104) sont disposées au sein d'un joint (206) étanche aux fluides et/ou étanche aux gaz.

6. Assemblage de mandrin pour maintenir un substrat ou une électrode maître dans un procédé ECPR, comprenant un mandrin selon l'une quelconque des revendications 1 à 5, et un mandrin antagoniste (300), ledit mandrin antagoniste procurant un toit (207) par-dessus ladite au moins une entrée (103, 205), et un joint (206) étanche aux fluides et/ou étanche aux gaz configuré pour renfermer en partie ladite au moins une entrée (103, 205).

7. Procédé de nettoyage d'une chambre d'impression fermée de manière hermétique après l'impression et la séparation d'un premier substrat et d'un deuxième substrat disposés sur des mandrins antagonistes (202, 204), ledit procédé comprenant une étape de rinçage comprenant :
l'injection d'un courant de fluide de rinçage à travers au moins une entrée (103) prévue sur une surface de mandrin (202) qui entoure la circonférence d'une surface d'interaction, sur un côté du premier substrat et du deuxième substrat, à travers le premier substrat et le deuxième substrat ; et
évacuer le fluide de rinçage à travers au moins une sortie (104) prévue sur la surface de mandrin (202) qui entoure la circonférence d'une surface d'interaction, sur l'autre côté du premier substrat et du deuxième substrat.

8. Procédé selon la revendication 7, dans lequel le premier substrat est une électrode maître pour l'impression ECPR et ladite chambre d'impression est une chambre d'impression ECPR.

9. Procédé selon la revendication 8, comprenant la mise en oeuvre d'une étape de séchage après l'étape de rinçage, ladite étape de séchage comprenant :
l'injection d'un courant de fluide de séchage à travers ladite au moins une entrée (103) et l'évacuation du fluide de séchage à travers ladite au moins une sortie (104).

10. Procédé selon l'une quelconque des revendications 8 ou 9, dans lequel le nombre d'entrées (103, 205) et/ou de sorties (104) s'élève de 2 à 10, par exemple de 3 à 6.

11. Procédé selon la revendication 10, dans lequel des entrées différentes (103, 205) sont ouvertes pendant différents laps de temps et différentes sorties sont ouvertes de manière correspondante pendant différents laps de temps.

12. Procédé selon l'une quelconque des revendications 9 à 12, comprenant le fait de soumettre le mandrin supérieur et/ou le mandrin inférieur à un mouvement alternatif ascendant/descendant au cours de l'injection du fluide de séchage.

13. Procédé selon l'une quelconque des revendications 9 à 12, dans lequel le fluide de séchage est de l'azote, de l'hélium ou de l'argon.

14. Procédé selon l'une quelconque des revendications 9 à 13, dans lequel l'évacuation comprend l'aspiration du fluide de séchage à travers au moins une sortie dans la chambre ECPR.

15. Procédé selon l'une quelconque des revendications 9 à 14, dans lequel l'étape de séchage est mise en marche et l'étape de rinçage est mise à l'arrêt via une détection de la conductivité, du pH et/ou de la concentration dans le fluide de rinçage sortant, à l'aide d'un capteur ;
la comparaison de la valeur obtenue à une valeur seuil préétablie ; et
le passage du rinçage au séchage lorsque la valeur seuil est atteinte.
